# EUROPEAN PATENT SPECIFICATION

(11) **EP 2 911 234 B1**
(45) Date of publication and mention of the grant of the patent: **30.11.2016**
(21) Application number: 14177700.3
(22) Date of filing: 18.07.2014
(51) Int. Cl.: H01P 5/107, H01L 23/66, H01P 11/00, H01P 3/12, H01L 23/48

(54) **Millimeter wave bands semiconductor device**
Halbleiterbauelement mit Millimeterwellenbändern
Dispositif semi-conducteur de gammes d'ondes millimétriques

(30) Priority: 07.02.2014 JP 2014022064
(43) Date of publication of application: 26.08.2015
(73) Proprietor: Kabushiki Kaisha Toshiba, Tokyo 105-8001 (JP)
(72) Inventor: Takagi, Kazutaka, Minato-ku Tokyo 105-8001 (JP)
(74) Representative: Moreland, David

(56) References cited:
- JP-A- 2001 284 476
- US-A- 3 008 104
- US-A- 5 808 519
- US-A1- 2004 080 377
- US-A1- 2006 097 819
- US-B1- 6 239 669

## Description

### FIELD

Embodiments described herein relate generally to a millimeter wave bands semiconductor device.

### BACKGROUND

A conventional millimeter wave bands semiconductor package, on which a semiconductor chip operating in such a millimeter wave bands of 30 GHz or higher is mounted, includes a base body on which the semiconductor chip is placed, a signal line in which one end thereof is connected to the semiconductor chip and the other end acts as an antenna, and a cover body which is provided on the base body to cover the semiconductor chip. Such a conventional millimeter wave bands semiconductor package is used by inserting the signal line into a waveguide which is connected to an external electrical circuit or the like.

However, the conventional millimeter wave bands semiconductor package which was disclosed in Japan Patent Number 3485520 has two waveguide blocks for an input terminal antenna and an output terminal antenna. Since the two waveguide blocks are separate components, the installation states of the waveguide blocks for the antennas are changed at each terminal antenna. Accordingly, there is a problem in that a millimeter wave bands semiconductor device in which the semiconductor chip is mounted on the millimeter wave bands semiconductor package is poor in reproducibility.

More particularly, since the loss in the millimeter wave bands is affected by flatness of a metal surface, metal components such as the base body and the cover body may not be manufactured by inexpensive casting but has been manufactured using methods such as cutting work or metal mold casting (aluminum die casting). However, the cutting method is available to produce small quantities, but is expensive in manufacturing cost. Further, the metal mold casting (aluminum die casting) method is also available to produce, but similarly leads to an increase in manufacturing cost since an expensive metal is used.

US 5 808 519 relates to a millimetre-wave structure and, more particularly, to a device that guides signals to the vicinity of a device through a waveguide and makes a low-loss connection through an E-plane probe in which a microwave IC chip is reliably hermetically sealed and attenuation of the signals is suppressed.
6184640-1-RGRANLEE

US 3 008 104 relates to a high temperature flexible hollow tube waveguide which is capable of withstanding high temperatures without loss of electrical or mechanical properties.

### BRIEF DESCRIPTION OF THE DRAWINGS

FIG. 1 is an exploded perspective view illustrating schematically a millimeter wave bands semiconductor device according to a first embodiment when viewed obliquely from above;
FIG. 2 is an exploded perspective view illustrating schematically the millimeter wave bands semiconductor device according to the first embodiment when viewed obliquely from below;
FIG. 3A is a perspective view illustrating schematically a base body of a millimeter wave bands semiconductor package of the millimeter wave bands semiconductor device according to the first embodiment when viewed obliquely from above;
FIG. 3B is a cross-sectional view illustrating schematically the base body taken along the dashed-dotted line A-A' in FIG. 3A;
FIG. 4A is a perspective view illustrating schematically a circuit board of the millimeter wave bands semiconductor package of the millimeter wave bands semiconductor device according to the first embodiment when viewed obliquely from above;
FIG. 4B is a plan view illustrating schematically the circuit board of the millimeter wave bands semiconductor package of the millimeter wave bands semiconductor device according to the first embodiment when viewed from above;
FIG. 4C is a plan view illustrating schematically the circuit board of the millimeter wave bands semiconductor package of the millimeter wave bands semiconductor device according to the first embodiment when viewed from below;
FIG. 4D is a cross-sectional view illustrating schematically the circuit board taken along the dashed-dotted line B-B' in FIG. 4A;
FIG. 5A is a perspective view illustrating schematically a cover body of the millimeter wave bands semiconductor package of the millimeter wave bands semiconductor device according to the first embodiment when viewed obliquely from above;
FIG. 5B is a cross-sectional view illustrating schematically the cover body taken along the dashed-dotted line C-C' in FIG. 5A;
FIG. 6 is a cross-sectional view corresponding to FIGS. 3B, 4D, and 5B illustrating the millimeter wave bands semiconductor device according to the first embodiment;
FIG. 7A is a perspective view illustrating schematically a base body of a millimeter wave bands semiconductor package of the millimeter wave bands semiconductor device according to a second embodiment when viewed obliquely from above;
FIG. 7B is a cross-sectional view illustrating schematically the base body taken along the dashed-dotted line A-A' in FIG. 7A;
FIG. 8A is a perspective view illustrating schematically a cover body of the millimeter wave bands semiconductor package of the millimeter wave bands semiconductor device according to the second embodiment when viewed obliquely from above;
FIG. 8B is a cross-sectional view illustrating schematically the cover body taken along the dashed-dotted line C-C' in FIG. 8A;
FIG. 9 is a cross-sectional view corresponding to FIGS. 7B and 8B illustrating the millimeter wave bands semiconductor device according to the second embodiment;
FIG. 10A is a perspective view illustrating schematically a cover body of a millimeter wave bands semiconductor package of the millimeter wave bands semiconductor device according to a modified example of the second embodiment when viewed obliquely from above; and
FIG. 10B is a cross-sectional view illustrating schematically the cover body taken along the dashed-dotted line C-C' in FIG. 10A.

### DESCRIPTION OF THE EMBODIMENTS

In a first aspect, the present invention provides a millimeter wave bands semiconductor device as recited in claim 1.

A millimeter wave bands semiconductor device according to embodiments will be described below.

### (First Embodiment)

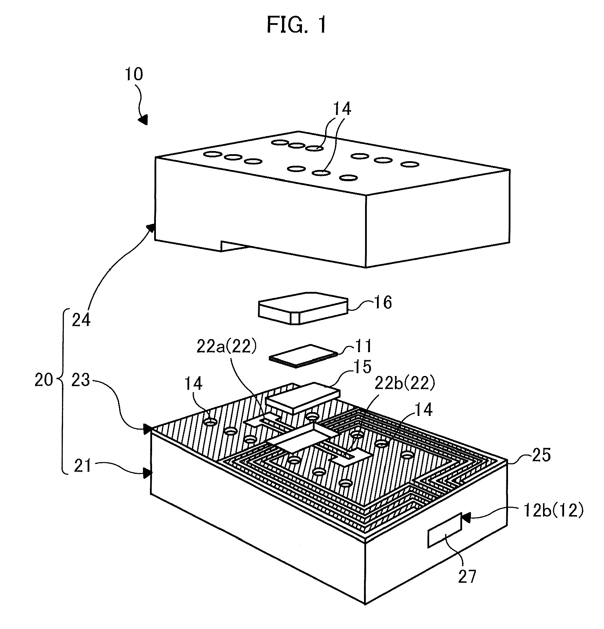

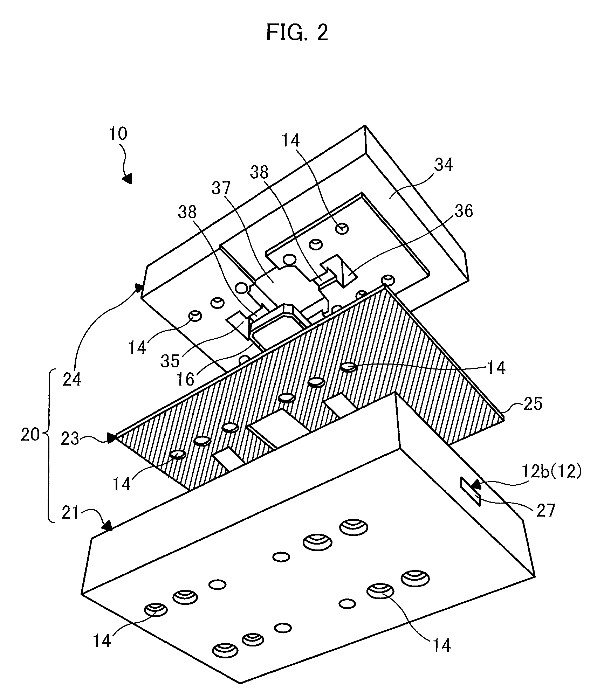

FIG. 1 is an exploded perspective view illustrating schematically a millimeter wave bands semiconductor device according to a first embodiment when viewed obliquely from above. In addition, FIG. 2 is an exploded perspective view illustrating schematically the millimeter wave bands semiconductor device according to the first embodiment when viewed obliquely from below. As illustrated in FIGS. 1 and 2, in a millimeter wave bands semiconductor device 10 according to the first embodiment, a semiconductor chip 11 is mounted inside a millimeter wave bands semiconductor package 20. The millimeter wave bands semiconductor package 20 includes a base body 21 as a first metal block, a circuit board 23 provided with signal lines 22 and the like, and a cover body 24 as a second metal block.

Each of the base body 21 as the first metal block and the cover body 24 as the second metal block constituting the millimeter wave bands semiconductor package 20 is a cuboid metal block. Further, the circuit board 23 is configured such that a desired circuit pattern or the like is formed on a front side surface of a dielectric substrate 25 and a desired pattern is also formed on a back side surface of the dielectric substrate 25.

Such a millimeter wave bands semiconductor package 20 will be described in detail below.

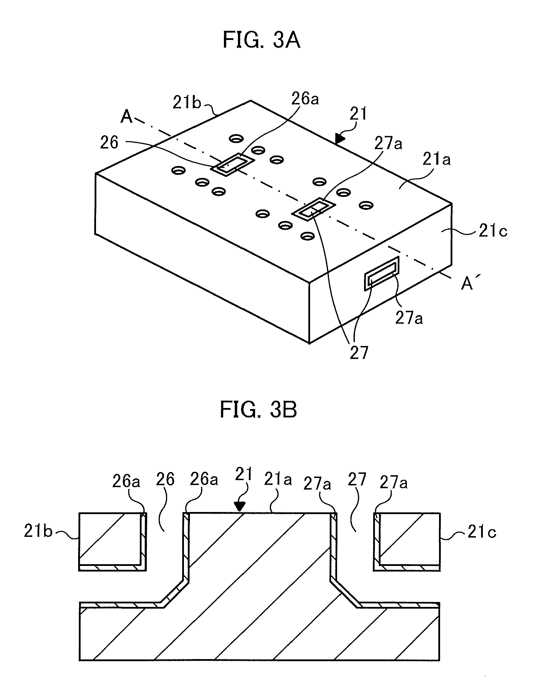

FIG. 3A is a perspective view illustrating schematically the base body 21 of the millimeter wave bands semiconductor package 20 of the millimeter wave bands semiconductor device 10 according to the first embodiment when viewed obliquely from above. In addition, FIG. 3B is a cross-sectional view illustrating schematically the base body 21 taken along the dashed-dotted line A-A' in FIG. 3A.

As illustrated in FIGS. 3A and 3B, a first penetration hole 26 and a second penetration hole 27 each of which is bending into L-shaped are provided in the cuboid base body 21 as the first metal block to penetrate the base body 21 toward side surfaces 21 b and 21 c from a front side surface 21 a. The first penetration hole 26 is provided to penetrate the base body 21 toward the first side surface 21 b from the front side surface 21 a, and the second penetration hole 27 is provided to penetrate the base body 21 toward the second side surface 21 c opposite to the first side surface 21 b from the front side surface 21 a. Each of the penetration holes 26 and 27 constitutes a waveguide 12, through which millimeter waves are guided, together with non-penetration holes 35 and 36 of the cover body 24 which will be described below.

As illustrated in FIG. 3A, each of the penetration holes 26 and 27 is a penetration hole of a so-called E-plane bend type having a horizontally long shape in cross section, but each of the penetration holes 26 and 27 may be a penetration hole of a so-called H-plane bend type having a vertical long shape in cross section. However, when each of the penetration holes 26 and 27 is formed in the H-plane bend type, the base body 21 becomes thicker. Accordingly, it is preferable that each of the penetration holes 26 and 27 is the penetration hole of the so-called E-plane bend type, as illustrated in FIG. 3A.

In addition, the base body 21 may be made of a metal, but is preferably made of a metal such as Cu having excellent heat conductivity in order to improve radiation performance of heat emitted from the semiconductor chip 11 (see FIGS. 1 and 2) mounted on the front side surface 21 a of the base body 21.

It is possible to manufacture the above-described base body 21 by bonding, for example, cutting-processed metallic plates. However, according to this manufacturing manner, a manufacturing cost increases and mass productivity becomes poor. Here, in order to realize mass production, the base body 21 is manufactured by a casting method using a sand mold or a gypsum mold. However, when the base body 21 is manufactured by the casting, the surface roughness of the base body 21 manufactured using the sand mold is, for example, about 200 µm, and the surface roughness of the base body 21 manufactured using the gypsum mold is, for example, about 25 µm. Therefore, the inner surfaces of the penetration holes 26 and 27 are also rough. Since the penetration holes 26 and 27 become a part of the waveguide 12, as the inner surfaces of the penetration holes 26 and 27 are rough, a loss of the millimeter waves guided through the waveguide 12 is large.

Here, in order to reduce the loss of the millimeter waves, flattening films 26a and 27a are provided on the inner surfaces of the penetration holes 26 and 27. Each of the flattening films 26a and 27a is a film including, for example, Ag nanoparticles. When these flattening films 26a and 27a are provided, the surface roughness of the inner surface of the penetration holes 26 and 27 can be reduced to be about 1/10 level compared with a case where the flattening films 26a and 27a are not provided.

Further, die casting is well known as a casting method in which the surface roughness is relatively low. However, the die casting is a casting method which is applicable to only a metal such as Al having a low melting point due to restriction of a mold to be used and is not applicable to a metal such as Cu having excellent heat conductivity but having a high melting point.

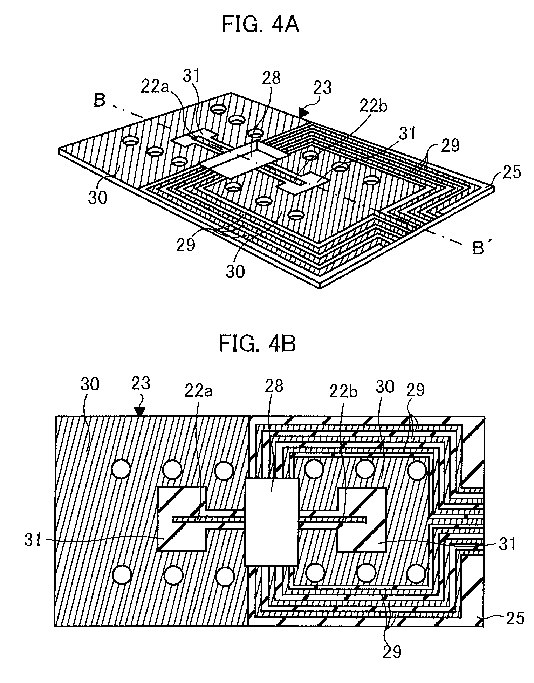

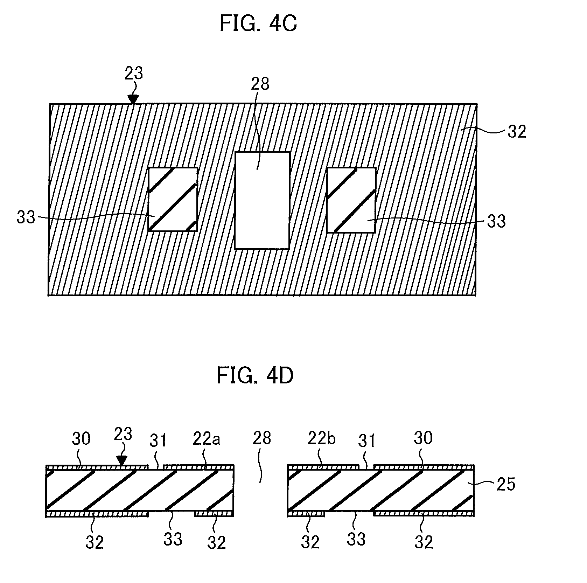

FIG. 4A is a perspective view illustrating schematically the circuit board 23 of the millimeter wave bands semiconductor package 20 of the millimeter wave bands semiconductor device 10 according to the first embodiment when viewed obliquely from above. In addition, FIG. 4B is a plan view illustrating schematically the circuit board 23 of the millimeter wave bands semiconductor package 20 of the millimeter wave bands semiconductor device 10 according to the first embodiment when viewed from above and FIG. 4C is a plan view illustrating schematically the circuit board 23 of the millimeter wave bands semiconductor package 20 of the millimeter wave bands semiconductor device 10 according to the first embodiment when viewed from below. Further, FIG. 4D is a cross-sectional view illustrating schematically the circuit board 23 taken along the dashed-dotted line B-B' in FIG. 4A.

As illustrated in FIGS. 4A to 4D, the circuit board 23 is configured such that a desired circuit pattern or the like is formed on the front side surface of the dielectric substrate 25 and a desired pattern is also formed on the back side surface of the dielectric substrate 25.

The dielectric substrate 25 is formed of, for example, ceramic or the like in a plate shape, and a substantially rectangular penetration hole 28 is provided in a substantially central region of the dielectric substrate 25 to dispose the semiconductor chip 11 or the like.

As illustrated in FIGS. 4A, 4B, and 4D, a circuit pattern including input/output signal lines 22a and 23b, a plurality of bias supplying lines 29, and a first ground pattern 30 is provided on the front side surface of the dielectric substrate 25 by a metal thin film, for example, Cu or the like.

The input signal line 22a extends by a predetermined distance toward one side of the dielectric substrate 25 from a long side of the substantially rectangular penetration hole 28, on the front side surface of the dielectric substrate 25. One end of the input signal line 22a receives millimeter waves guided through the waveguide 12 which will be described below. In addition, the other end of the input signal line 22a guides the received millimeter waves to the semiconductor chip 11 which is electrically connected to the other end.

The output signal line 22b extends by a predetermined distance toward a direction opposite to the extending direction of the input signal line 22a from a long side of the penetration hole 28 facing the long side which comes in contact with the input signal line 22a, on the front side surface of the dielectric substrate 25. One end of the output signal line 22b receives the millimeter waves guided from the semiconductor chip 11 which is electrically connected to the one end. In addition, the other end of the output signal line 22b transmits the received millimeter waves to the waveguide 12.

Accordingly, the predetermined distances of the input signal line 22a and the output signal line 22b refer to a distance longer than the lengths of these signal lines 22a and 22b which are capable of acting as a monopole antenna for transmitting and receiving the millimeter waves guided through the waveguide 12, respectively.

The plurality of bias supplying lines 29 elongates along a peripheral portion of the dielectric substrate 25 from, for example, a short side of the substantially rectangular penetration hole 28 and extends to come in contact with one side of the dielectric substrate 25, respectively, on the front side surface of the dielectric substrate 25. These bias supplying lines 29 are lines to supply a DC bias to the semiconductor chip 11, respectively.

The first ground pattern 30 is provided on the approximately entire front side surface of dielectric substrate 25 to be insulated from the input signal line 22a, the output signal line 22b, and the plurality of bias supplying lines 29. The first ground pattern 30 is removed in a substantially rectangular shape in the vicinity of one end of the input signal line 22a, and the first ground pattern 30 is removed in a substantially rectangular shape in the vicinity of the other end of the output signal line 22b.

Further, the substantially rectangular front side region of the dielectric substrate 25, which is exposed by the removal of the ground pattern 30 in this manner, is a region included in the waveguide 12 to be described below. Therefore, the substantially rectangular front side region of the dielectric substrate 25, which is exposed by the removal of the first ground pattern 30, is referred to as a front waveguide region 31.

Next, as illustrated in FIGS. 4C and 4D, a second ground pattern 32 is provided on the back side surface of the dielectric substrate 25 by a metal thin film, for example, Cu or the like. The second ground pattern 32 is provided on the approximately entire back side surface of the dielectric substrate 25, but the region corresponding to the front waveguide region 31 is removed. The ground pattern 30 and the ground pattern 32 are electrically connected to each other by a plurality of through holes (not illustrated in the drawings).

Further, similar to the front side region, the substantially rectangular back side region of the dielectric substrate 25, which is exposed by the removal of the ground pattern 32 in this manner, is also a region included in the waveguide 12 to be described below. Therefore, the substantially rectangular back side region of the dielectric substrate 25, which is exposed by the removal of the second ground pattern 32, is referred to as a rear waveguide region 33.

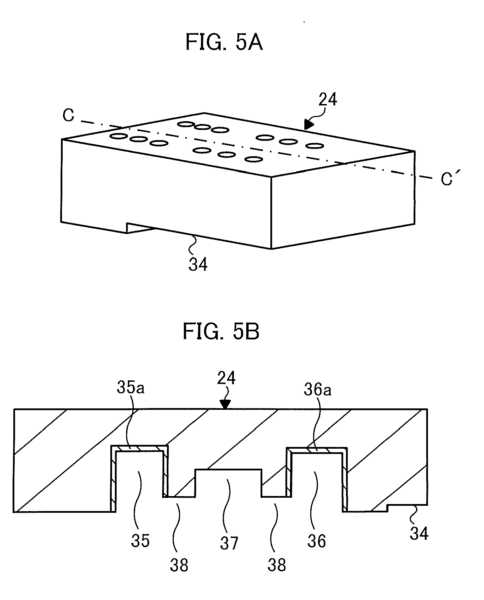

FIG. 5A is a perspective view illustrating schematically the cover body 24 of the millimeter wave bands semiconductor package 20 of the millimeter wave bands semiconductor device 10 according to the first embodiment when viewed obliquely from above. In addition, FIG. 5B is a cross-sectional view illustrating schematically the cover body taken along the dashed-dotted line C-C' in FIG. 5A.

The cuboid cover body 24 as the second metal block is disposed on the above-described circuit board 23, but, as illustrated in FIGS. 5A, 5B, and 2, respectively, a ring-shaped region 34, which faces the bias supplying line 29, of the back side surface of the cover body 24 is shallowly hollowed out to suppress the contact between the cover body 24 and the bias supplying line 29.

As illustrated in FIGS. 5B and 2, a first non-penetration hole 35 and a second non-penetration hole 36 are provided in the cover body 24 having such a ring-shaped region 34, respectively.

The first non-penetration hole 35 and the second non-penetration hole 36 extend by a predetermined distance toward the front side surface from the back side surface and are provided so as not to penetrate the cover body 24, respectively. As described above, the non-penetration holes 35 and 36 constitute the waveguides 12, through which millimeter waves are guided, together with the penetration holes 26 and 27 of the base body 21, respectively.

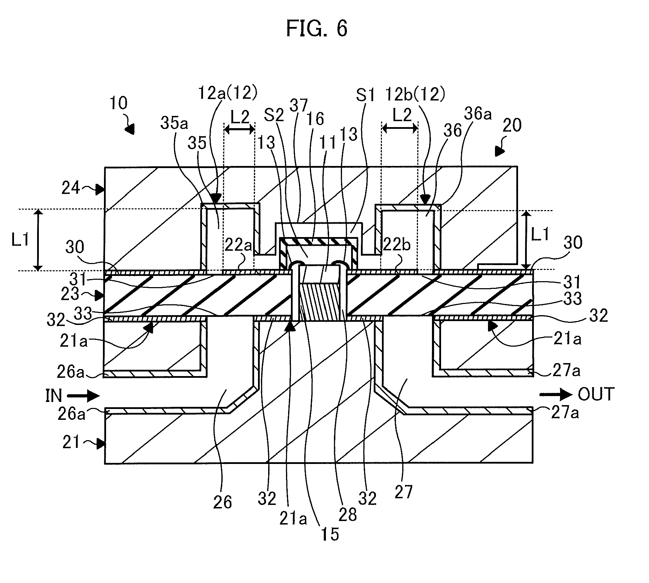

Further, the predetermined distances of the first non-penetration hole 35 and the second non-penetration hole 36 refer to such a distance that a distance L1 (see FIG. 6) from the front surface of the circuit board 23 to the bottom surface of the non-penetration holes 35 and 36 becomes λ/4 (where λ is a wavelength of the millimeter wave to be used) when the cover body 24 is placed on the circuit board 23.

Further, as illustrated in FIGS. 5B and 2, in the rear surface of the cover body 24, a first recessed portion 37 is provided between the first non-penetration hole 35 and the second non-penetration hole 36 such that the semiconductor chip 11 is disposed and second recessed portions 38 are provided such that each of the non-penetration holes 35 and 36 is connected to the first recessed portion 37.

Similar to the base body 21, in order to realize mass production, the above-described cover body 24 is also manufactured by the casting method using the sand mold or the gypsum mold. For this reason, flattening films 35a and 36a are also provided on the inner surfaces of the non-penetration holes 35 and 36. When these flattening films 35a and 36a are provided, the surface roughness of the inner surfaces of the non-penetration holes 35 and 36 can be reduced to be about 1/10 level compared with a case where the flattening films 35a and 36a are not provided.

FIG. 6 is a cross-sectional view corresponding to FIGS. 3B, 4D, and 5B illustrating the millimeter wave bands semiconductor device 10 in which the semiconductor chip 11 is mounted on the above-described millimeter wave bands semiconductor package 20.

As illustrated in FIG. 6, the circuit board 23 is mounted on the front side surface 21 a of the base body 21 such that the rear waveguide regions 33 provided in the back side surface of the circuit board 23 are disposed on a top of the first penetration hole 26 and a top of the second penetration hole 27 of the base body 21 and the second ground pattern 32 on the back side surface of the circuit board 23 comes in contact with the front side surface 21 a of the base body 21. In addition, the cover body 24 is mounted on the circuit board 23 such that the first non-penetration hole 35 and the second non-penetration hole 36 are disposed on the front waveguide regions 31 of the circuit board 23 and the back side surface thereof comes in contact with the first ground pattern 30 on the front side surface of the circuit board 23.

Then, as illustrated in FIGS. 1 and 2, screw holes 14 are provided to penetrate through each of the base body 21, the circuit board 23, and the cover body 24, and the base body 21, the circuit board 23, and the cover body 24 are fixed to each other by insertion of fixing screws into these screw holes 14.

In the millimeter wave bands semiconductor package 20 configured in this manner, the first penetration hole 26 of the base body 21 and the first non-penetration hole 35 of the cover body 24 constitute the first waveguide 12a including the front waveguide region 31 and the rear waveguide region 33 of the circuit board 23 therein. Similarly, the second penetration hole 27 of the base body 21 and the second non-penetration hole 36 of the cover body 24 constitute the second waveguide 12b including the front waveguide region 31 and the rear waveguide region 33 of the circuit board 23 therein.

Further, in the millimeter wave bands semiconductor package 20 configured in this manner, the input/output signal lines 22a and 22b of the circuit board 23 are in a state of being inserted into these waveguides 12a and 12b by L2 = λ/4 (where λ is a wavelength of the millimeter wave to be used), respectively, to act as a monopole antenna.

The semiconductor chip 11 operating in the millimeter wave is mounted in the above-described millimeter wave bands semiconductor package 20. The semiconductor chip 11 is, for example, a field effect transistor (FET) which amplifies power of the millimeter waves.

The semiconductor chip 11 is mounted on the front side surface of the base body 21 via a metal chip mount plate 15. The semiconductor chip 11 is placed on the front side surface of the base body 21 together with the chip mount plate 15 so as to be disposed in a space S1 which is surrounded substantially by the front side surface of the base body 21, the side surface of the penetration hole 28 of the circuit board 23, and the first recessed portion 37 of the cover body 24.

Further, a recessed chip cover body 16 formed of, for example, a dielectric material such as ceramic is disposed in the first recessed portion 37 of the cover body 24. Accordingly, in more detail, the semiconductor chip 11 is placed on the front side surface of the base body 21 together with the chip mount plate 15 so as to be disposed in a space S2 which is surrounded substantially by the front side surface of the base body 21, the side surface of the penetration hole 28 of the circuit board 23, and the chip cover body 1

The semiconductor chip 11 placed in this manner is electrically connected to the other end of the input signal line 22a of the circuit board 23 by a connection conductor, for example, a wire 13 or the like and is also electrically connected to one end of the output signal line 22b of the circuit board 23 by the connection conductor, for example, the wire 13 or the like.

In the millimeter wave bands semiconductor device 10 in which the semiconductor chip 11 is mounted in the millimeter wave bands semiconductor package 20 in this manner, when the millimeter waves are input into the first waveguide 12a from an arrow IN direction in FIG. 6, the millimeter waves are guided through the first waveguide 12a and received at the input signal line 22a which is inserted and disposed within the first waveguide 12a.

The received millimeter waves are input to the semiconductor chip 11 via the input signal line 22a and are subjected to the desired signal processing (for example, power amplification) in the semiconductor chip 11.

When the signal-processed millimeter waves are output to the output signal line 22b from the semiconductor chip 11, the millimeter waves are transmitted into the second waveguide 12b from the output signal line 22b. The millimeter waves transmitted into the second waveguide 12b are guided through the second waveguide 12b and are output to an arrow OUT direction in FIG. 6.

According to the millimeter wave bands semiconductor device 10 of the first embodiment described above, since the waveguides 12a and 12b, through which the millimeter waves are guided, are embedded in the millimeter wave bands semiconductor package 20, it is possible to provide the millimeter wave bands semiconductor device 10 in which, for example, a change in relative position between the input/output signal lines 22a and 22b and the waveguides 12a and 12b is suppressed and reproducibility is excellent.

When the relative position between the input/output signal lines 22a and 22b and the waveguides 12a and 12b is shifted by, for example, 0.5 mm, the power loss of the millimeter waves is about 3 dB (about half). Accordingly, the excellent reproducibility and, for example, the arrangement of the input/output signal lines 22a and 22b with high accuracy at a desired position of the waveguides 12a and 12b are very important in the millimeter wave bands semiconductor device 10.

In addition, according to the millimeter wave bands semiconductor device 10 of the first embodiment, since the flattening films 26a, 27a, 35a, and 36a are provided in the inner surfaces of the waveguides 12a and 12b, through which the millimeter waves are guided, the loss of the millimeter waves to be guided can be reduced even when the metal components as the first and second metal blocks are manufactured using an inexpensive casting method in which flatness is poor, and thus it is possible to inexpensively provide the millimeter wave bands semiconductor device 10.

Further, according to the millimeter wave bands semiconductor device 10 of the first embodiment, the first and second penetration holes 26 and 27, which are provided in the base body 21 to constitute the waveguides 12a and 12b as a main body, penetrate the base body 21 toward the side surfaces 21b and 21 c from the front side surface 21 a. Accordingly, the back side surface of the base body 21 can be fixed to a cooling mechanism such as a heat radiation fin. As a result, a heat radiation property can be improved.

### (Second Embodiment)

A millimeter wave bands semiconductor device according to a second embodiment differ from the millimeter wave bands semiconductor device 10 according to the first embodiment in that a penetration hole to constitute a waveguide is provided in a cover body as a first metal block and a non-penetration hole to constitute the waveguide is provided in a base body as a second metal block. The millimeter wave bands semiconductor device according to the second embodiment will be described below. Further, the same portions as in the millimeter wave bands semiconductor device 10 according to the first embodiment will be denoted by the same reference numerals and the description will be not presented.

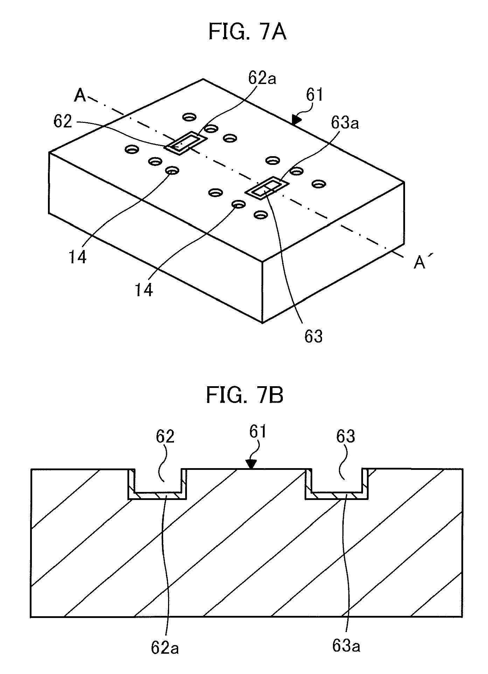

FIG. 7A is a perspective view illustrating schematically a base body 61 of a millimeter wave bands semiconductor package 60 of a millimeter wave bands semiconductor device according to the second embodiment when viewed obliquely from above. In addition, FIG. 7B is a cross-sectional view illustrating schematically the base body 61 taken along the dashed-dotted line A-A' in FIG. 7A.

As illustrated in FIGS. 7A and 7B, a first non-penetration hole 62 and a second non-penetration hole 63 extend by a predetermined distance toward a back side surface from a front side surface and are provided in the cuboid base body 61 as the second metal block so as not to penetrate the base body 61. These non-penetration holes 62 and 63 constitute a waveguides 51, through which millimeter waves are guided, together with penetration holes 65 and 66 of a cover body 64 to be described below, respectively.

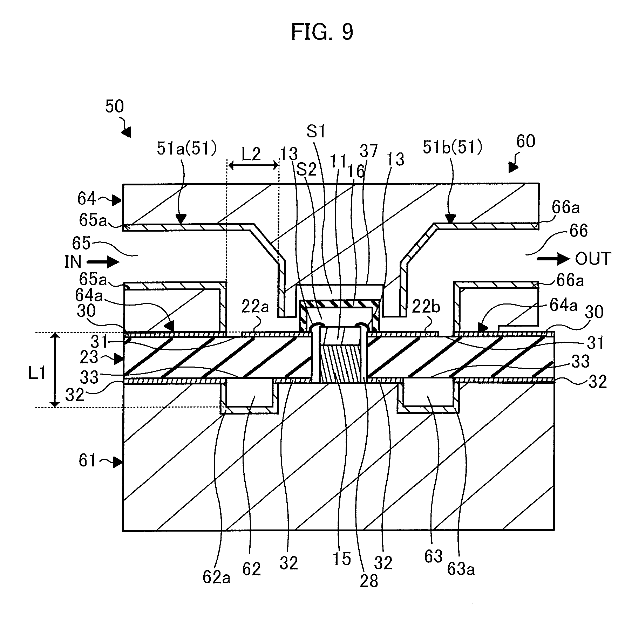

Further, the predetermined distances of the first non-penetration hole 62 and the second non-penetration hole 63 refer to such a distance that a distance L1 (see FIG. 9) from a front side surface of a circuit board 23 to a bottom surface of the non-penetration holes 62 and 63 becomes λ/4 (where λ is a wavelength of millimeter waves to be used) when the circuit board 23 is placed on the front side surface of the base body 61.

In addition, for the same reason as the base body 21 of the millimeter wave bands semiconductor package 20 according to the first embodiment, flattening films 62a and 63a are also provided on an inner surfaces of the non-penetration holes 62 and 63 of the above-described base body 61. When these flattening films 62a and 63a are provided, the surface roughness of the inner surfaces of the non-penetration holes 62 and 63 can be reduced to be about 1/10 level compared with a case where the flattening films 62a and 63a are not provided.

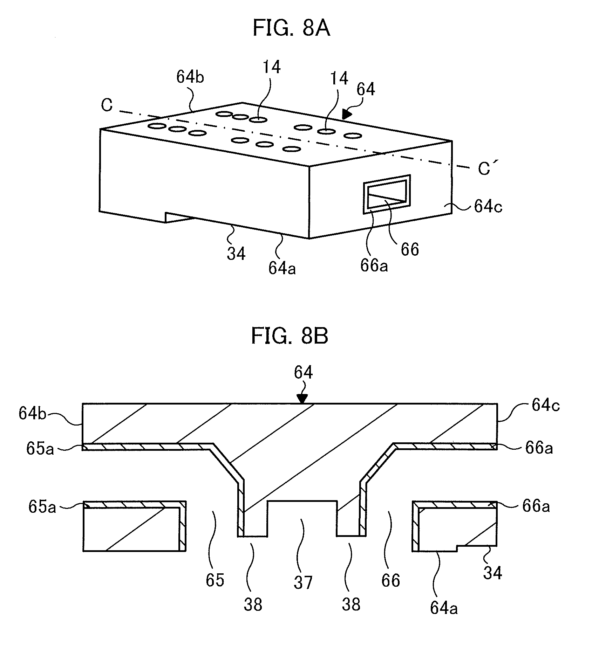

FIG. 8A is a perspective view illustrating schematically the cover body 64 of the millimeter wave bands semiconductor package 60 of the millimeter wave bands semiconductor device according to the second embodiment when viewed obliquely from above. In addition, FIG. 8B is a cross-sectional view illustrating schematically the cover body 64 taken along the dashed-dotted line C-C' in FIG. 8A.

A first penetration hole 65 and a second penetration hole 66 each of which is bending into L-shaped are provided in the cuboid cover body 64 as the first metal block to penetrate the cover body 64 toward side surfaces 64b and 64c from a back side surface 64a. The first penetration hole 65 is provided to penetrate the cover body 64 toward the first side surface 64b from the back side surface 64a, and the second penetration hole 66 is provided to penetrate the cover body 64 toward the second side surface 64c opposite to the first side surface 64b from the back side surface 64a. Each of the penetration holes 65 and 66 constitutes the waveguide 51, through which the millimeter waves are guided, together with non-penetration holes 62 and 63 of the base body 61.

As illustrated in FIG. 8A, each of the penetration holes 65 and 66 is a penetration hole of a so-called E-plane bend type having a horizontally long shape in cross section, but each of the penetration holes 65 and 66 may be a penetration hole of a so-called H-plane bend type having a vertical long shape in cross section.

For the same reason as the cover body 24 of the millimeter wave bands semiconductor package 20 of the millimeter wave bands semiconductor device according to the first embodiment, flattening films 65a and 66a are also provided on the inner surfaces of the penetration holes 65 and 66 of the above-described cover body 64. When these flattening films 65a and 66a are provided, the surface roughness of the inner surface of the penetration holes 65 and 66 can be reduced to be about 1/10 level compared with a case where the flattening films 65a and 66a are not provided.

FIG. 9 is a cross-sectional view corresponding to FIGS. 7B and 8B illustrating a millimeter wave bands semiconductor device 50 in which a semiconductor chip 11 is mounted on the millimeter wave bands semiconductor package 60 including the base body 61 and the cover body 64 described above.

As illustrated in FIG. 9, the circuit board 23 is mounted on the front side surface of the base body 61 such that a rear waveguide regions 33 provided in the back side surface of the circuit board 23 are disposed on a top of the first non-penetration hole 62 and a top of the second non-penetration hole 63 of the base body 61 and a second ground pattern 32 on the back side surface of the circuit board 23 comes in contact with the front side surface of the base body 61. In addition, the cover body 64 is mounted on the circuit board 23 such that the first penetration hole 65 and the second penetration hole 66 are disposed on a front waveguide regions 31 of the circuit board 23 and the back side surface 64a thereof comes in contact with the first ground pattern 30 on the front side surface of the circuit board 23.

Then, similar to FIGS. 1 and 2, screw holes 14 (see FIGS. 7A) are provided to penetrate through each of the base body 61, the circuit board 23, and the cover body 64, and the base body 61, the circuit board 23, and the cover body 64 are fixed to each other by insertion of fixing screws into these screw holes 14.

In the millimeter wave bands semiconductor package 60 configured in this manner, the first non-penetration hole 62 of the base body 61 and the first penetration hole 65 of the cover body 64 constitute a first waveguide 51a including the front waveguide region 31 and the rear waveguide region 33 of the circuit board 23 therein. Similarly, the second non-penetration hole 63 of the base body 61 and the second penetration hole 66 of the cover body 64 constitute a second waveguide 51 b including the front waveguide region 31 and the rear waveguide region 33 of the circuit board 23 therein.

Further, in the millimeter wave bands semiconductor package 60 configured in this manner, input/output signal lines 22a and 22b of the circuit board 23 are in a state of being inserted into these waveguides 51 a and 51 b by L2 = λ/4 (where λ is a wavelength of the millimeter wave to be used), respectively, to act as a monopole antenna.

Similar to the millimeter wave bands semiconductor device 10 according to the first embodiment, the semiconductor chip 11 operating in the millimeter wave is mounted in the above-described millimeter wave bands semiconductor package 60.

In the millimeter wave bands semiconductor device 50 in which the semiconductor chip 11 is mounted in the millimeter wave bands semiconductor package 60 in this manner, when the millimeter waves are input into the first waveguide 51a from an arrow IN direction in FIG. 9, the millimeter waves are guided through the first waveguide 51 a and received at the input signal line 22a which is inserted and disposed within the first waveguide 51 a.

The received millimeter waves are input to the semiconductor chip 11 via the input signal line 22a and are subjected to the desired signal processing (for example, power amplification) in the semiconductor chip 11.

When the signal-processed millimeter waves are output to the output signal line 22b from the semiconductor chip 11, the millimeter waves are transmitted into the second waveguide 51 b from the output signal line 22b. The millimeter waves transmitted into the second waveguide 51 b are guided through the second waveguide 51 b and are output to an arrow OUT direction in FIG. 9.

Even in the millimeter wave bands semiconductor device 50 according to the second embodiment described above, since the waveguides 51 a and 51 b, through which the millimeter waves are guided, are embedded in the millimeter wave bands semiconductor package 60, it is possible to provide the millimeter wave bands semiconductor device 50 in which reproducibility is excellent.

Further, even in the millimeter wave bands semiconductor device 50 according to the second embodiment, since the flattening films 62a, 63a, 65a, and 66a are provided in the inner surfaces of the waveguides 51 a and 51 b, through which the millimeter waves are guided, it is possible to provide the millimeter wave bands semiconductor device 50 in which the loss of the millimeter waves to be guided can be reduced.

Further, in the millimeter wave bands semiconductor device 50 according to the second embodiment, the first and second penetration holes 65 and 66, which constitute the waveguides 51 a and 51 b as a main body, are provided in the cover body 64. Accordingly, the back side surface of the base body 61 can be fixed to a cooling mechanism such as a heat radiation fin. As a result, the heat radiation property can be improved.

Moreover, according to the millimeter wave bands semiconductor device 50 of the second embodiment, the first and second penetration holes 65 and 66, which constitute the waveguides 51 a and 51 b as a main body, are provided in the cover body 64. Accordingly, it is possible to provide the millimeter wave bands semiconductor device 50 in which the heat radiation property is more excellent.

That is, as described in the first embodiment, even when the first and second penetration holes 26 and 27, which constitute the waveguides 12a and 12b as a main body, are provided in the base body 21 and the first and second non-penetration holes 35 and 36 are provided in the cover body 24, it is possible to provide the millimeter wave bands semiconductor package 20 and the millimeter wave bands semiconductor device 10 in which the waveguides 12a and 12b are embedded. However, when the first and second penetration holes 26 and 27, which constitute the waveguides as a main body, are provided in the base body 21 which also acts as a radiation plate of heat emitted from the semiconductor chip 11, the first and second penetration holes 26 and 27 restrict a heat radiation path and the heat radiation property is deteriorated.

On the other hand, as in the second embodiment, when the first and second penetration holes 65 and 66, which constitute the waveguides 51 a and 51 b as a main body, are provided in the cover body 64, the first and second non-penetration holes 62 and 63 having a volume smaller than the penetration holes 65 and 66 can be provided in the base body 61 and the restriction of the heat radiation path by the provision of the waveguides 51 a and 51 b can be alleviated, compared with the case of the first embodiment. Accordingly, it is possible to provide the millimeter wave bands semiconductor device 50 in which the heat radiation property is more excellent.

While certain embodiments have been described, these embodiments have been presented by way of example only, and are not intended to limit the scope of the inventions as defined by the appended claims.. Indeed, the novel embodiments described herein may be embodied in a variety of other forms; furthermore, various omissions, substitutions and changes in the form of the embodiments described herein may be made without departing from the scope of the inventions as defined by the appended claims.

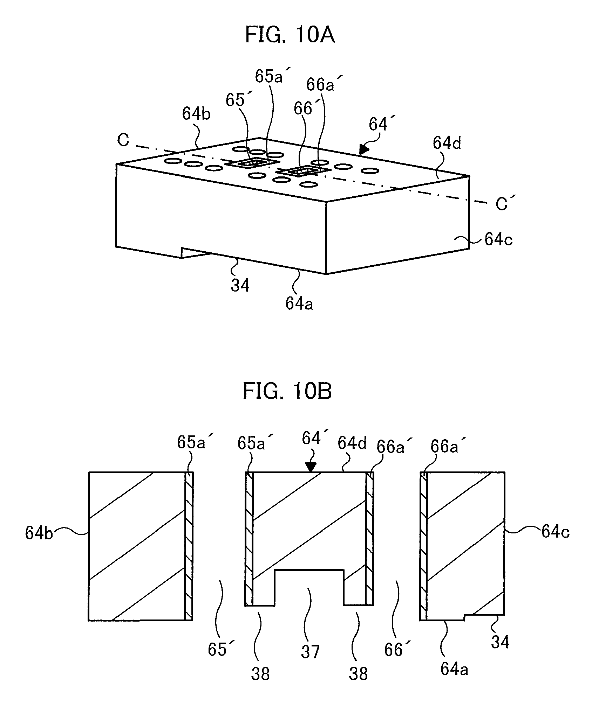

For example, in the second embodiment, first and second penetration holes 65' and 66' may be provided to penetrate a cover body 64' toward a front side surface 64d from a back side surface 64a as illustrated in FIGS. 10A and 10B. Further, since flattening films 65a' and 66a' are provided in the penetration holes 65' and 66', as in the cover body 64 of the second embodiment, the surface roughness of the inner surfaces of the penetration holes 65' and 66' can be reduced to about be 1/10 level compared with a case where the flattening films 65a' and 66a' are not provided. Like this, even when the first and second penetration holes 65' and 66' are provided, it is possible to obtain the same effects as in the millimeter wave bands semiconductor device 50 according to the second embodiment.

## Claims

1. A millimeter wave bands semiconductor device comprising:
a first metal block (21) including a first penetration hole (26) and a second penetration hole (27);
a second metal block (24) including a first non-penetration hole (35) and a second non-penetration hole (36); and
a circuit board (23) that is disposed between the first metal block (21) and the second metal block (24) and that has an input signal line (22a) and an output signal line (22b) on a front side surface thereof,
wherein the first metal block (21) and the second metal block (24) are disposed such that the first non-penetration hole (35) and the first penetration hole (26) constitute a first waveguide and the second non-penetration hole (36) and the second penetration hole (27) constitute a second waveguide,
**characterised in that**
the first waveguide has a flattening film (26a, 35a) which contains Ag nanoparticles on an inner surface thereof, and
the second waveguide has a flattening film (27a, 36a) which contains Ag nanoparticles on an inner surface thereof.

2. The millimeter wave bands semiconductor device according to claim 1, wherein the circuit board (23) includes a penetration hole (28) and the millimeter wave bands semiconductor device further includes a semiconductor chip (11) that is disposed in the penetration hole (28) of the circuit board (23) and is electrically connected to the input signal line (22a) and the output signal line (22b).

3. The millimeter wave bands semiconductor device according to claim 1 or 2, wherein the first metal block (21) and the second metal block (24) are manufactured by a casting method using a sand mold or a gypsum mold, respectively.

4. The millimeter wave bands semiconductor device according to claim 1 or 2, wherein one end of the input signal line (22a) is inserted by a length of λ/4 into the first waveguide, and
one end of the output signal line (22b) is inserted by a length of λ/4 into the second waveguide.

5. The millimeter wave bands semiconductor device according to claim 1 or 2, wherein the first non-penetration hole (36) is provided such that a bottom surface thereof is disposed at a position by a length of λ/4 apart from the input signal line (22a), and the second non-penetration hole (37) is provided such that a bottom surface thereof is disposed at a position by a length of λ/4 apart from the output signal line (22b).

6. The millimeter wave bands semiconductor device according to claim 1 or 2, wherein the first metal block (21) is a base body of which the circuit board (23) is disposed on a front side surface, and
the second metal block (24) is a cover body which is disposed on the circuit board (23).

7. The millimeter wave bands semiconductor device according to claim 6, wherein each of the first penetration hole (26) and the second penetration hole (27) of the base body (21) is a penetration hole bending into L-shaped, which penetrates the base body (21) toward a side surface (21 b, 21 c) from the front side surface (21 a).

8. The millimeter wave bands semiconductor device according to claim 6, wherein a bias supplying line (29) is further provided on the front side surface of the circuit board (23) to supply a DC bias to the semiconductor chip (11), and
a region (34), which faces the bias supplying line (29), of a back side surface of the cover body (24) is hollowed out so as to be shallower than the other region.

9. The millimeter wave bands semiconductor device according to claim 8, wherein a first ground pattern (30) is provided on the front side surface of the circuit board (23), and
the first ground pattern (30) is provided so as to be insulated from the input signal line (22a), the output signal line(22b), and the bias supplying line (29).

10. The millimeter wave bands semiconductor device according to claim 1 or 2, wherein the first metal block (64)is a cover body which is disposed on the circuit board (23), and
the second metal block (61) is a base body of which the circuit board (23) is disposed on a front side surface.

11. The millimeter wave bands semiconductor device according to claim 10, wherein each of the first penetration hole (65) and the second penetration hole (66) of the cover body (61) is a penetration hole bending into L-shaped, which penetrates the cover body (61) toward a side surface from a back side surface.

12. The millimeter wave bands semiconductor device according to claim 10, wherein each of the first penetration hole (65) and the second penetration hole (66) of the cover body (64) is a penetration hole, which penetrates the cover body (64) toward a front side surface from a back side surface.

13. The millimeter wave bands semiconductor device according to claim 10, wherein a bias supplying line (29) is further provided on the front side surface of the circuit board (23) to supply a DC bias to the semiconductor chip (11), and
a region (34), which faces the bias supplying line (29), of a back side surface of the cover body (64) is hollowed out so as to be shallower than the other region.

14. The millimeter wave bands semiconductor device according to claim 13, wherein a first ground pattern (30) is provided on the front side surface of the circuit board (23), and
the first ground pattern (30) is provided so as to be insulated from the input signal line (22a), the output signal line (22b), and the bias supplying line (29).

## Patentansprüche

1. Halbleiterbauelement mit Millimeterwellenbändern, umfassend:
einen ersten Metallblock (21), einschließend eine erste Durchdringungsöffnung (26) und eine zweite Durchdringungsöffnung (27);
einen zweiten Metallblock (24), einschließend eine erste Nicht-Durchdringungsöffnung (35) und eine zweite Nicht-Durchdringungsöffnung (36); und
eine Leiterplatte (23), die zwischen dem ersten Metallblock (21) und dem zweiten Metallblock (24) angeordnet ist und eine Eingangssignalleitung (22a) und eine Ausgangssignalleitung (22b) an einer diesbezüglichen vorderen Seitenfläche aufweist,
wobei der erste Metallblock (21) und der zweite Metallblock (24) so angeordnet sind, dass die erste Nicht-Durchdringungsöffnung (35) und die erste Durchdringungsöffnung (26) einen ersten Wellenleiter darstellen und die zweite Nicht-Durchdringungsöffnung (36) und die zweite Durchdringungsöffnung (27) einen zweiten Wellenleiter darstellen, **dadurch gekennzeichnet, dass**
der erste Wellenleiter einen Einebnungsfilm (26a, 35a) aufweist, der Ag-Nanopartikel an einer diesbezüglichen Innenfläche enthält und
der zweite Wellenleiter einen Einebnungsfilm (27a, 36a) aufweist, der Ag-Nanopartikel an einer diesbezüglichen Innenfläche enthält.

2. Halbleiterbauelement mit Millimeterwellenbändern nach Anspruch 1, wobei die Leiterplatte (23) eine Durchdringungsöffnung (28) einschließt und das Halbleiterbauelement mit Millimeterwellenbändern ferner einen Halbleiter-Chip (11) einschließt, der in der Durchdringungsöffnung (28) der Leiterplatte (23) angeordnet ist und elektrisch mit der Eingangssignalleitung (22a) und der Ausgangssignalleitung (22b) verbunden ist.

3. Halbleiterbauelement mit Millimeterwellenbändern nach Anspruch 1 oder 2, wobei der erste Metallblock (21) und der zweite Metallblock (24) jeweils durch ein Gießverfahren unter Verwendung einer Sandform oder einer Gipsform hergestellt werden.

4. Halbleiterbauelement mit Millimeterwellenbändern nach Anspruch 1 oder 2, wobei ein Ende der Eingangssignalleitung (22a) mit einer Länge von λ/4 in den ersten Wellenleiter eingebracht wird und
ein Ende der Ausgangssignalleitung (22b) mit einer Länge von λ/4 in den zweiten Wellenleiter eingebracht wird.

5. Halbleiterbauelement mit Millimeterwellenbändern nach Anspruch 1 oder 2, wobei die erste Nicht-Durchdringungsöffnung (36) so bereitgestellt wird, dass eine untere Fläche davon an einer Position mit einer Länge von λ/4 entfernt von der Eingangssignalleitung (22a) angeordnet ist und
die zweite Nicht-Durchdringungsöffnung (37) so bereitgestellt wird, dass eine untere Fläche davon an einer Position mit einer Länge von λ/4 entfernt von der Ausgangssignalleitung (22b) angeordnet ist.

6. Halbleiterbauelement mit Millimeterwellenbändern nach Anspruch 1 oder 2, wobei der erste Metallblock (21) ein Grundkörper ist, dessen Leiterplatte (23) an einer vorderen Seitenfläche angeordnet ist und
der zweite Metallblock (24) ein Abdeckungskörper ist, der auf der Leiterplatte (23) angeordnet ist.

7. Halbleiterbauelement mit Millimeterwellenbändern nach Anspruch 6, wobei jede der ersten Durchdringungsöffnung (26) und der zweiten Durchdringungsöffnung (27) des Grundköpers (21) eine Durchdringungsöffnung ist, die sich in eine L-Form biegt und den Grundkörper (21) von der vorderen Seitenfläche (21a) zu einer Seitenfläche (21b, 21c) durchdringt.

8. Halbleiterbauelement mit Millimeterwellenbändern nach Anspruch 6, wobei eine Vorspannungszufuhrleitung (29) ferner an der vorderen Seitenfläche der Leiterplatte (23) bereitgestellt wird, um dem Halbleiter-Chip (11) eine Gleichstromvorspannung zuzuführen und
ein Bereich (34) einer hinteren Seitenfläche des Abdeckungskörpers (24), welcher der Vorspannungszufuhrleitung (29) gegenüberliegt, ausgehöhlt wird, um flacher zu sein als der andere Bereich.

9. Halbleiterbauelement mit Millimeterwellenbändern nach Anspruch 8, wobei eine erste Massestruktur (30) an der vorderen Seitenfläche der Leiterplatte (23) bereitgestellt wird und
die erste Massestruktur (30) so bereitgestellt wird, dass sie von der Eingangssignalleitung (22a), der Ausgangssignalleitung (22b) und der Vorspannungszufuhrleitung (29) isoliert ist.

10. Halbleiterbauelement mit Millimeterwellenbändern nach Anspruch 1 oder 2, wobei der erste Metallblock (64) ein Abdeckungskörper ist, der auf der Leiterplatte (23) angeordnet ist und
der zweite Metallblock (61) ein Grundkörper ist, dessen Leiterplatte (23) an einer vorderen Seitenfläche angeordnet ist.

11. Halbleiterbauelement mit Millimeterwellenbändern nach Anspruch 10, wobei jede der ersten Durchdringungsöffnung (65) und der zweiten Durchdringungsöffnung (66) des Abdeckungsköpers (61) eine Durchdringungsöffnung ist, die sich in eine L-Form biegt und den Abdeckungskörper (61) von einer hinteren Seitenfläche zu einer Seitenfläche durchdringt.

12. Halbleiterbauelement mit Millimeterwellenbändern nach Anspruch 10, wobei jede der ersten Durchdringungsöffnung (65) und der zweiten Durchdringungsöffnung (66) des Abdeckungsköpers (61) eine Durchdringungsöffnung ist, die den Abdeckungskörper (64) von einer hinteren Seitenfläche zu einer vorderen Seitenfläche durchdringt.

13. Halbleiterbauelement mit Millimeterwellenbändern nach Anspruch 10, wobei eine Vorspannungszufuhrleitung (29) ferner an der vorderen Seitenfläche der Leiterplatte (23) bereitgestellt wird, um dem Halbleiter-Chip (11) eine Gleichstromvorspannung zuzuführen und
ein Bereich (34) einer hinteren Seitenfläche des Abdeckungskörpers (64), welcher der Vorspannungszufuhrleitung (29) gegenüberliegt, ausgehöhlt wird, um flacher zu sein als der andere Bereich.

14. Halbleiterbauelement mit Millimeterwellenbändern nach Anspruch 13, wobei eine erste Massestruktur (30) an der vorderen Seitenfläche der Leiterplatte (23) bereitgestellt wird und
die erste Massestruktur (30) so bereitgestellt wird, dass sie von der Eingangssignalleitung (22a), der Ausgangssignalleitung (22b) und der Vorspannungszufuhrleitung (29) isoliert ist.

## Revendications

1. Dispositif semi-conducteur à ondes millimétriques, comprenant :
un premier bloc de métal (21) comprenant un premier trou de débouchant (26) et un deuxième trou de débouchant (27) ;
un deuxième bloc de métal (24) comprenant un premier trou de non-débouchant (35) et un deuxième trou de non-débouchant (36) ; et
une carte de circuit imprimé (23) qui est agencée entre le premier bloc de métal (21) et le deuxième bloc de métal (24) et qui présente une ligne de signal d'entrée (22a) et une ligne de signal de sortie (22b) sur une surface latérale avant de celle-ci,
dans lequel le premier bloc de métal (21) et le deuxième bloc de métal (24) sont agencés de telle manière que le premier trou de non-débouchant (35) et le premier trou de débouchant (26) constituent un premier guide d'ondes et le deuxième trou de non-débouchant (36) et le deuxième trou de débouchant (27) constituent un deuxième guide d'ondes,
**caractérisé en ce que**
le premier guide d'ondes présente un film d'aplanissement (26a, 35a) qui contient des nanoparticules d'Ag sur une surface interne de celui-ci, et
le deuxième guide d'ondes présente un film d'aplanissement (27a, 36a) qui contient des nanoparticules d'Ag sur une surface interne de celui-ci.

2. Dispositif semi-conducteur à ondes millimétriques selon la revendication 1, dans lequel la carte de circuit imprimé (23) comprend un trou de débouchant (28) et le dispositif semi-conducteur à ondes millimétriques comprend en outre une puce à semi-conducteur (11) qui est agencée dans le trou de débouchant (28) de la carte de circuit imprimé (23) et est électriquement raccordée à la ligne de signal d'entrée (22a) et à la ligne de signal de sortie (22b).

3. Dispositif semi-conducteur à ondes millimétriques selon la revendication 1 ou 2, dans lequel le premier bloc de métal (21) et le deuxième bloc de métal (24) sont fabriqués grâce à un procédé de moulage utilisant un moule en sable ou un moule en gypse, respectivement.

4. Dispositif semi-conducteur à ondes millimétriques selon la revendication 1 ou 2, dans lequel une extrémité de la ligne de signal d'entrée (22a) est insérée d'une longueur de λ/4 dans le premier guide d'ondes, et
une extrémité de la ligne de signal de sortie (22b) est insérée d'une longueur de λ/4 dans le deuxième guide d'ondes.

5. Dispositif semi-conducteur à ondes millimétriques selon la revendication 1 ou 2, dans lequel le premier trou de non-débouchant (36) est fourni de telle manière qu'une surface inférieure de celui-ci est agencée au niveau d'une position éloignée d'une longueur de λ/4 par rapport à la ligne de signal d'entrée (22a), et
le deuxième trou de non-débouchant (37) est fourni de telle manière qu'une surface inférieure de celui-ci est agencée au niveau d'une position éloignée d'une longueur de λ/4 par rapport à la ligne de signal de sortie (22b).

6. Dispositif semi-conducteur à ondes millimétriques selon la revendication 1 ou 2, dans lequel le premier bloc de métal (21) est un corps de base dont la carte de circuit imprimé (23) est agencée sur une surface latérale avant, et
le deuxième bloc de métal (24) est un corps de protection qui est agencé sur la carte de circuit imprimé (23).

7. Dispositif semi-conducteur à ondes millimétriques selon la revendication 6, dans lequel chacun parmi le premier trou de débouchant (26) et le deuxième trou de débouchant (27) du corps de base (21) est un trou de débouchant coudé en forme de L, qui pénètre dans le corps de base (21) en direction d'une surface latérale (21b, 21c) à partir de la surface latérale avant (21a).

8. Dispositif semi-conducteur à ondes millimétriques selon la revendication 6, dans lequel une ligne de polarisation (29) est en outre fournie sur la surface latérale avant de la carte de circuit imprimé (23) afin de fournir une polarisation CC à la puce à semi-conducteur (11), et
une région (34), qui fait face à la ligne de polarisation (29), d'une surface latérale arrière du corps de protection (24) est creusée de manière à être moins profonde que l'autre région.

9. Dispositif semi-conducteur à ondes millimétriques selon la revendication 8, dans lequel un premier motif de mise à la terre (30) est fourni sur la surface latérale avant de la carte de circuit imprimé (23), et
le premier motif de mise à la terre (30) est fourni de manière à être isolé par rapport à la ligne de signal d'entrée (22a), à la ligne de signal de sortie (22b), et à la ligne de polarisation (29).

10. Dispositif semi-conducteur à ondes millimétriques selon la revendication 1 ou 2, dans lequel le premier bloc de métal (64) est un corps de protection qui est agencé sur la carte de circuit imprimé (23), et
le deuxième bloc de métal (61) est un corps de base dont la carte de circuit imprimé (23) est agencée sur une surface latérale avant.

11. Dispositif semi-conducteur à ondes millimétriques selon la revendication 10, dans lequel chacun parmi le premier trou de débouchant (65) et le deuxième trou de débouchant (66) du corps de protection (61) est un trou de débouchant coudé en forme de L qui pénètre dans le corps de protection (61) en direction d'une surface latérale à partir d'une surface latérale arrière.

12. Dispositif semi-conducteur à ondes millimétriques selon la revendication 10, dans lequel chacun parmi le premier trou de débouchant (65) et le deuxième trou de débouchant (66) du corps de protection (61) est un trou de débouchant qui pénètre dans le corps de protection (61) en direction d'une surface latérale avant à partir d'une surface latérale arrière.

13. Dispositif semi-conducteur à ondes millimétriques selon la revendication 10, dans lequel une ligne de polarisation (29) est en outre fournie sur la surface latérale avant de la carte de circuit imprimé (23) afin de fournir une polarisation CC à la puce à semi-conducteur (11), et
une région (34), qui fait face à la ligne de polarisation (29), d'une surface latérale arrière du corps de protection (64) est creusée de manière à être moins profonde que l'autre région.

14. Dispositif semi-conducteur à ondes millimétriques selon la revendication 13, dans lequel un premier motif de mise à la terre (30) est fourni sur la surface latérale avant de la carte de circuit imprimé (23), et
le premier motif de mise à la terre (30) est fourni de manière à être isolé par rapport à la ligne de signal d'entrée (22a), à la ligne de signal de sortie (22b), et à la ligne de polarisation (29).
